Europäisches Patentamt

European Patent Office

Office européen des brevets

(11) Numéro de publication: **0 026 138**
**B1**

(12) **FASCICULE DE BREVET EUROPEEN**

(45) Date de publication du fascicule du brevet: **14.12.83**

(51) Int. Cl.³: **F 02 P 3/04**

(21) Numéro de dépôt: **80401330.8**

(22) Date de dépôt: **19.09.80**

(54) **Dispositif électronique de commande d'une bobine d'allumage pour moteur à combustion interne et moteur comportant un tel dispositif.**

(30) Priorité: **21.09.79 FR 7923602**

(43) Date de publication de la demande:
**01.04.81 Bulletin 81/13**

(45) Mention de la délivrance du brevet:
**14.12.83 Bulletin 83/50**

(84) Etats contractants désignés:
**DE GB IT**

(56) Documents cités:
**DE - A - 2 821 085**
**FR - A - 2 356 826**
**US - A - 3 854 466**
**US - A - 3 940 658**

(73) Titulaire: **PSA ETUDES ET RECHERCHES**
**75, Avenue de la Grande Armée**
**F-75016 Paris (FR)**

(72) Inventeur: **Xiberas, André**
**"THOMSON-CSF" SCPI 173, Bld Haussmann**
**F-75360 Paris Cedex 08 (FR)**

(74) Mandataire: **Letellier, Bernard et al,**
**THOMSON-CSF SCPI 173, Bld Haussmann**
**F-75379 Paris Cedex 08 (FR)**

Courier Press, Leamington Spa, England.

## Dispositif électronique de commande d'une bobine d'allumage pour moteur à combustion interne et moteur comportant un tel dispositif

L'invention se rapporte à la technique des systèmes électroniques d'allumage, du type inductif, pour moteur à combustion interne. Elle concerne, plus précisément, un dispositif électronique de commande du courant magnétisant traversant l'enroulement primaire de la bobine d'allumage, comportant un circuit de protection contre les surtensions rencontrées en service ou accidentelles.

Les systèmes d'allumage classiques font appel à un rupteur électromécanique dont on connaît les principaux inconvénients: érosion électrique rapide des contacts sous forte charge, facteur de fermeture constant et limité par la vitesse d'ouverture mécanique des contacts, phénomènes de rebondissement liés aux caractéristiques de résonance mécanique des lames élastiques.

Dans le but de remédier aux inconvénients précités du rupteur électronique, il a déjà été proposé, notamment dans l'US—A—3 940 658 et l'US—A—3 854 466 de substituer au rupteur électromécanique, un transistor de commutation dans lequel le collecteur est connecté à l'enroulement primaire de la bobine d'allumage et d'effectuer la commande du courant magnétisant traversant en portant alternativement le transistor de commutation de l'état saturé à l'état bloqué. La commande de ce transistor de commutation est fournie par un signal de commande à deux états qui est appliqué sur la base de ce transistor, ce signal de commande, synchrone de la rotation du moteur est délivré par capteur d'entrée soit mécanique, mais plus généralement d'un type électronique.

Les avantages procurés par l'utilisation d'une transistor de commutation ne doivent pas faire perdre de vue les limitations d'utilisation résultant des caractéristiques des jonctions dans les semiconducteurs, notamment la tension directe de claquage du collecteur. Lorsque le transistor se bloque, la surtension qui apparaît aux bornes de l'enroulement primaire dépend, certes, de la valeur de condensateur d'accord disposé aux bornes du transistor mais aussi directement de l'impédance de charge de l'enroulement secondaire: résistances d'étincelle et d'encrassement de la bougie d'allumage ou encore de la résistance en circuit ouvert résultant du débranchement occasionnel ou accidentel d'une des bougies d'ignition.

Dans le but d'assurer la sécurité de fonctionnement du transistor de commutation, il est nécessaire de limiter la tension aux bornes de ce transistor à une valeur maximale spécifiée pour le type de transistor utilisé et de prévoir, à cet effet, un moyen de protection efficace contre les surtensions, compte tenu de la rapidité de montée de la surtension (10 à 20 $\mu$s et des tensions de crête mises en jeu (350 à 500 volts). Le moyen de protection, universellement utilisé, est constitué essentiellement par une diode Zener connectée entre le collecteur de transistor et l'entrée de commande de ce transistor, la tension de coude de cette diode Zener étant inférieure à la tension de claquage de transistor. La grandeur du signal aux bornes de l'enroulement secondaire de la bobine d'allumage doit pouvoir atteindre, en service normal, une valeur de l'ordre de 30 kV. Compte tenu de rapport de transformation de la bobine, de l'ordre de 60 à 100, la grandeur du signal aux bornes de l'enroulement primaire, c'est-à-dire sur le collecteur du transistor est de l'ordre de 300 à 500 V. La tension de coude de la diode Zener de protection doit être comprise entre cette valeur de 300 à 500 V. et la tension de claquage de transistor. En fait, dans la pratique, cette diode Zener de protection doit être constituée par deux diodes Zener dont la tension de coude se situe dans la gamme des 200 V.

Ce moyen de protection par diode Zener présente divers inconvénients: les technologies actuelles ne permettent pas d'intégrer de telles diodes Zener au transistor de commutation, le coefficient de température de ces diodes varie en sens inverse de celui du transistor, la tension de coude des diodes Zener de la classe des 200 V et plus est largement dispersée. Il résulte des inconvénients ci-dessus: une dispersion dans les caractéristiques électriques des dispositifs de commande et une marge de protection réduite.

C'est le but de l'invention de remédier aux inconvénients des dispositifs, de l'art antérieur, protégés par des diodes Zener, un autre but de l'invention est d'intégrer le moyen de protection au transistor de commutation.

L'object de l'invention est un dispositif de commande d'une bobine d'allumage pour moteur à combustion interne. Ce dispositif comprend une bobine d'allumage ayant un enroulement primaire et un enroulement secondaire, un transistor de commutation dans lequel le collecteur est connecté à l'enroulement primaire. Ce dispositif reçoit un signal de commande à deux états, synchrone de la rotation du moteur, afin de bloquer ou de rendre conducteur le transistor de commutation, ce dispositif est caractérisé en ce qu'il comporte en outre un circuit de protection contre les surtensions aux bornes du transistor de commutation, ce circuit de protection étaut intégré au transistor de commutation, et incluant, connectés en boucle les éléments suivants: un comparateur de niveau ayant une première entrée reliée par l'intermédiaire d'un réseau diviseur, au collecteur du transistor de commutation et une seconde entrée reliée à une source de tension continue de référence; un amplificateur d'erreur relié à la sortie de ce comparateur de niveau et connecté à P'eutrée de commande de transistor de commutation; un circuit de sommation qui reçoit, d'une part, le signal de sortie de l'amplificateur d'erreur et, d'autre part, le signal de commande à deux états pour rendre conducteur le transistor de commutation dès qu'une surtension est détectée par le comparateur de niveau. La sortie de ce circuit de sommation étant reliée à la base du transistor de commutation afin de protéger ce dernier des surtensions détectées par le comparateur de niveau, de manière à rendre conducteur ce transistor de commutation lorsque le signal de commande à deux états est un niveau correspondant au blocage du courant magnétisant, traversant la bobine d'allumage.

Par transistor de commutation, il faut entendre, soit un transistor unique, ou plus généralement une combinaison de plusieurs transistors. L'enroulement secondaire de la bobine d'allumage peut être du type à sortie unique ou du type à sorties symétriques, sans modifier en rien le fonctionnement du dispositif.

D'autres caractéristiques de l'invention apparaîtront dans la description détaillée qui va suivre, faite en regard des dessins annexés. Sur ces dessins:

—la figure 1 représente, sous la forme d'un bloc diagramme, un dispositif de commande selon l'invention,

—la figure 2 représente, sous la forme d'une bloc diagramme, un mode de réalisation d'un dispositif de commande de la figure 1.

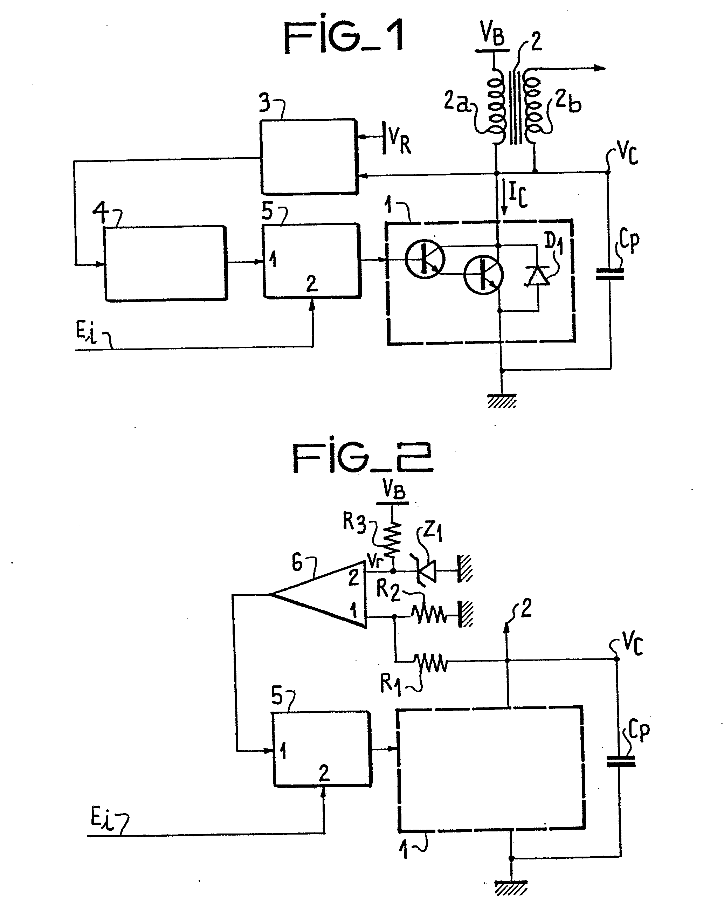

La figure 1 représente, sous la forme d'un bloc diagramme, un dispositif de commande, selon l'invention, qui comprend les éléments suivants:

—un transistor de commutation 1, réalisé sous la forme d'un montage de Darlington, par exemple, est placé en série avec l'enroulement primaire 2a, d'une bobine d'allumage 2, l'enroulement secondaire 2b de cette bobine étant relié aux bougies d'ignition du moteur, la diode $D_1$ est un élément de protection du transistor contre les tensions inverses et l'élément $C_p$ la capacité shunt du montage,

—un comparateur de niveau 3, la première entrée duquel est reliée au point de jonction du transistor 1 et l'enroulement primaire 2a de la bobine d'allumage et la seconde entrée est reliée à une source de tension continue de référence $V_R$, de l'ordre de quelques volts,

—un amplificateur d'erreur 4, relié à la sortie du comparateur précédent,

—un circuit de sommation 5, la première entrée duquel est reliée à la sortie de l'amplificateur précédent et la seconde entrée reçoit un signal de commande $E_I$ à deux états, synchrone de la rotation du moteur, ce circuit pour être un simple réseau résistif.

Le fonctionnement de ce dispositif de commande est le suivant: lorsque le signal de commande $E_I$ est au niveau haut, le transistor 1 est à l'état saturé et un courant $I_c$ fourni par la source d'énergie électrique $V_B$, traverse la bobine d'allumage 2, lorsque le signal $E_I$ bascule au niveau bas, le transistor 1 passe à l'état bloqué; dès cet instant, la tension $V_c$ aux bornes de la capacité Cp monte brusquement. Cette tension $V_c$ est comparée à la tension de référence $V_R$, après mise à l'échelle, par un facteur k, à l'aide d'un réseau diviseur non représenté sur la figure 1; si la condition $kV_c$ supérieure à $V_R$ se produit, un courant est injecté dans la base du transistor 1 qui devient conducteur et maintient l'accroissement de la tension $V_c$ en deçà de la tension de claquage de ce transistor. Le fonctionnement du dispositif est identique lorsque les bougies d'ignition sont déconnectées.

La figure 2 représente, sous la forme d'un bloc diagramme, un mode de réalisation d'un dispositif de commande, selon l'invention. Les éléments 1, 2 et 5 sont identiques à ceux de la figure 1, le comparateur de niveau 3 et l'amplificateur 4 sont combinés sous la forme d'un amplificateur différentiel 6, le réseau diviseur est constitué par les résistances $R_1$ et $R_2$ et la tension de référence $V_R$ est fournie par une diode Zener $Z_1$ connectée à la source électrique $V_B$ par une résistance $R_3$. Le fonctionnement du dispositif de la figure 2 reste identique à celui de la figure 1.

Les technologies de fabrication actuelles des circuits intégrés permettent d'intégrer au transistor de commutation les éléments qui constituent ce moyen de protection.

On voit maintenant plus clairement les avantages que présente un dispositif de commande selon l'invention, notamment tous les éléments constituant le dispositif peuvent être intégrés sur un substrat semiconducteur, la valeur de la surtension maximale peut être réglée aisément en ajustant la valeur du coefficient k de division, la fiabilité électrique est accrue et le coût du dispositif est sensiblement réduit.

Certaines modifications peuvent être apportées au dispositif décrit sans sortir du cadre de l'invention; par exemple, la tension de référence $V_R$ peut être obtenue directement à partir d'une source de de tension continue stabilisée et d'un diviseur résistif.

D'une manière générale, l'invention trouve des applications dans les dispositifs de commande, mettant en oeuvre des transistors de commutation opérant sur une charge selfique, ou un transformateur dont l'impédance de charge est susceptible de varier. D'une manière plus spécifique, l'invention trouve son application dans l'industrie automobile.

**Revendications**

1. Dispositif de commande d'une bobine d'allumage (2) pour moteur à combustion interne ayant une bobine d'allumage (2) comportant des enroulements primaire (2a) et secondaire (2b), et un transistor de commutation (1) dans lequel le collecteur est connecté à cet enroulement primaire (2a), ce dispositif étant commandé par un signal de commande ($E_i$) à deux états, synchrone de la rotation du moteur, afin de bloquer ou de rendre conducteur le transistor de commutation (1), dispositif caractérisé en ce qu'il comprend un circuit de protection contre les surtensions aux bornes du transistor de commutation (1), ce circuit de protection étant intégré au transistor de commutation (1) et incluant, connectés en boucle, les éléments suivants: un comparateur de niveau (3) ayant une première entrée reliée, par l'intermédiaire d'un réseau diviseur ($R_1$, $R_2$), au collecteur du transistor de commutation (1) et une seconde entrée reliée à une source de tension continue de référence ($V_r$); un amplificateur d'erreur (4) relié à la sortie du comparateur de niveau (3) et, connecté à l'entrée de commande du transistor de commutation (1), un circuit de sommation (5) qui reçoit, d'une part, le signal de commande ($E_i$) à deux états et d'autre part le signal de sortie de l'amplificateur d'erreur (4) pour rendre conducteur le transistor de commutation (1) dès qu'une surtension est détectée par le comparateur de niveau (3).

2. Dispositif selon la revendication 1, caractérisé en ce que le comparateur de niveau (3) et l'amplificateur d'erreur (4) sont constitués par un amplificateur différentiel (6) dans lequel la première entrée est reliée par l'intermédiaire d'un réseau diviseur ($R_1$, $R_2$) au collecteur de transistor de commutation (1) et la seconde entrée est reliée à une source de tension continue de référence ($V_r$).

3. Dispositif selon les revendications 1 et 2, caractérisé en ce que le réseau diviseur ($R_1$, $R_2$) est du type résistif.

4. Dispositif selon les revendications 1 et 2, caractérisé en ce que la source de tension continue de référence ($V_r$) est fournie par la tension de coude d'une diode Zéner basse tension ($Z_1$).

5. Moteur à combustion interne, caractérisé en ce qu'il est équipé d'un système d'allumage comprenant un dispositif de commande de la bobine d'allumage (2) selon l'une des revendications 1 à 4.

**Patentansprüche**

1. Steuervorrichtung für eine Zündspule (2) einer Maschine mit interner Verbrennung, deren Zündspule (2) eine Primärwicklung (2a) und eine Sekundärwicklung (2b) aufweist, mit einem Schalttransistor (1), dessen Kollektor mit dieser Primärwicklung (2a) verbunden ist, wobei diese Vorrichtung gesteuert ist durch ein Steuersignal ($E_i$), das zwei Zustände aufweisen kann und synchron mit der Drehung der Maschine ist, um den Schalttransistor (1) leitend oder sperrend zu machen, wobei diese Vorrichtung dadurch gekennzeichnet ist, daß sie eine Schutzschaltung zum Schutz gegen Überspannungen an den Anschlüssen des Schalttransistors (1) aufweist, wobei diese Schutzschaltung in den Schalttransistor (1) integriert ist und miteinander in eine Schleife geschaltet die folgenden Elemente enthält: Einen Pegelkomparator (3), dessen erster Eingang über ein Teilernetzwerk ($R_1$, $R_2$) mit dem Kollektor des Schalttransistors (1) verbunden ist und dessen zweiter Eingang mit einer Bezugsgleichspannungsquelle ($V_r$) verbunden ist; einen Fehlerverstärker (4), der mit dem Ausgang des Pegelkomparators (3) verbunden ist; und eine mit dem Steuereingang des Schalttransistors (1) verbundene Summierschaltung (5), die zum einen das zwei Zustände aufweisende Steuersignal ($E_i$) und zum anderen das Ausgangssignal des Fehlerverstärkers (4) empfängt, um den Schalttransistor (1) leitend zu steuern, sobald eine Überspannung durch den Pegelkomparator (3) festgestellt wird.

2. Vorrichtung nach Anspruch 1, dadurch gekennzeichnet, daß der Pegelkomparator (3) und der Fehlerverstärker (4) durch einen Differenzverstärker (6) gebildet sind, in dem der erste Eingang über ein Teilernetzwerk ($R_1$, $R_2$) mit dem Kollektor des Schalttransistors (1) verbunden ist und der zweite Eingang mit einer Bezugsgleichspannungsquelle ($V_r$) verbunden ist.

3. Vorrichtung nach den Ansprüchen 1 und 2, dadurch gekennzeichnet, daß das Teilernetzwerk ($R_1$, $R_2$) ein Widerstandsnetzwerk ist.

4. Vorrichtung nach den Ansprüchen 1 und 2, dadurch gekennzeichnet, daß die Bezugsgleichspannungsquelle ($V_r$) durch die Kniespannung einer Niederspannungs-Zenerdiode ($Z_1$) abgeleitet ist.

5. Maschine mit interner Verbrennung, dadurch gekennzeichnet, daß sie mit einer Zündanlage ausgerüstet ist, die eine Steuervorrichtung zu Steuerung der Zündspule (2) gemäß einem der Ansprüche 1 bis 4 enthält.

**Claims**

1. Control device for controlling the ignition coil (2) of an internal-combustion engine having an ignition coil (2) comprising primary (2a) and secondary (2b) windings, and a switching transistor (1) the collector of which is connected to said primary winding (2a), the device being controlled by a two-level control signal ($E_i$) which is synchronous with the rotation of the engine, in order to bias the switching transistor (1) into the blocking or conductive state, the device being characterized in that it comprises a protection circuit for protecting against excessive voltages at the terminals of the switching transistor (1), said protection circuit being integrated with the switching transistor (1) and comprising the following members connected into a loop: a level comparator (3) having a first input connected to the collector of the switching transistor (1) through a divider network ($R_1$, $R_2$) and a second input connected to a continuous reference voltage source ($V_r$); an error amplifier (4) connected to the output of the level comparator (3); and a summing circuit (5) connected to the control input of the switching transistor (1) and receiving, on the one hand, the two-level control signal ($E_i$) and, on the other hand, the output signal of the error amplifier (4) for biasing the switching transistor (1) into its conductive state as soon as an excessive voltage is detected by the level comparator (3).

2. Device in accordance with claim 1, characterized in that the level comparator (3) and the error amplifier (4) are formed by a differential amplifier (6) the first input of which is connected to the collector of the switching transistor (1) through a divider network ($R_1$, $R_2$) and the second input of which is connected to a continuous reference voltage source ($V_r$).

3. Device in accordance with claims 1 and 2, characterized in that the divider network ($R_1$, $R_2$) is of resistive type.

4. Device in accordance with claims 1 and 2, characterized in that the continuous reference voltage source ($V_r$) is provided by the knee voltage of a low voltage Zener diode ($Z_1$).

5. Internal-combustion engine, characterized in that it is equipped with an ignition system comprising a device for controlling the ignition coil (2) in accordance with any of claims 1 to 4.

# FIG_1

# FIG_2